# EUROPEAN PATENT APPLICATION

(11) **EP 2 110 673 A1**
(43) Date of publication of application: **21.10.2009**
(21) Application number: 08425258.4
(22) Date of filing: 17.04.2008
(51) Int. Cl.: G01R 1/073

(54) **Testing head having vertical probes provided with stopping means to avoid their upward and downward escape from respective guide holes**

(71) Applicant: Technoprobe S.p.A, 23870 Cernusco Lombardone (Lecco) (IT)
(72) Inventor: Crippa, Roberto, I-23870 Cernusco Lombardone (Lecco) (IT); Lazzari, Stefano c/o Technoprobe S.p.A., I-23870 Cernusco Lombardone (Lecco) (IT); Redaelli, Luca c/o Technoprobe S.p.A, I-23870 Cernusco Lombardone (Lecco) (IT)
(74) Representative: Zambardino, Umberto

(57) **Abstract**

A testing head (20) is described in this patent with unlocked vertical probes for checking the functionality of an electronic device (10) to be tested, comprising a lower plate-shaped support (2) provided with at least one lower guide hole (4), an upper plate-shaped support (3) provided with at least one upper guide hole (5), and at least one contact probe (16) housed in a corresponding lower guide hole (4) and a corresponding upper guide hole (5), each contact probe (16) comprising a rod-shaped central body (17) with predetermined longitudinal axis (H) that is axially slidable in said corresponding lower guide hole (4) and said corresponding upper guide hole (5), **characterised in that** said at least one contact probe (16) comprises stopping means formed on said rod-shaped body (17) adapted to abut against at least one of said lower plate-shaped support (2) and upper plate-shaped support (3) following a predetermined upward sliding of said rod-shaped body (17), thus preventing the upward exit of said at least one contact probe (16) from said corresponding lower guide hole (4) and said corresponding upper guide hole (5). According to a preferred embodiment, the testing head (20) further comprises means for preventing the drop by gravity of said at least one contact probe (16) through said corresponding lower guide hole (4) and said corresponding upper guide hole (5).

## Description

### Field of application

The present invention refers to a testing head with unlocked vertical probes for checking the functionality of an electronic device to be tested comprising at least one plate-shaped support provided with at least one guide hole for the housing of at least one contact probe, each contact probe having a central rod-shaped body terminating at the ends with a first contact tip for the mechanical and electrical contact with a contact pad of said electronic device to be tested and a second contact tip for the mechanical and electrical contact with a corresponding contact pad of a testing device.

The present invention also refers to a contact probe for a testing head of the aforesaid type.

### Prior art

As is known, a testing head is a device suitable for placing a plurality of contact pads of a microstructure in electrical contact with corresponding channels of a measurement machine that measures its performance, in particular electric performance, or generically performs the test.

The test performed on integrated circuits is suitable in particular for detecting and isolating defective circuits already in the production step. Normally, the testing heads are then used for the electrical test of the integrated circuits on wafers before cutting and mounting them inside a chip containment package.

A testing head essentially comprises a plurality of mobile contact elements or contact probes held by at least one pair of plates or substantially plate-shaped guides that are parallel to one another. Such guides are equipped with suitable holes and placed a certain distance apart so as to leave a free area or an air gap for the movement and possible deformation of the contact probes. The pair of guides in particular comprises an upper guide and a lower guide, both provided with guide holes in which the contact probes, normally formed from wires of special alloys with good electrical and mechanical properties, axially slide.

The good connection between the contact probes and the contact pads of the device being tested is ensured by the pressing of the testing head on the device itself, the contact probes, mobile in the guide holes made in the upper and lower guides, during such pressing contact undergoing a bending inside the air gap between the two guides and a sliding inside such guide holes. Testing heads of this type are commonly known as vertical probes.

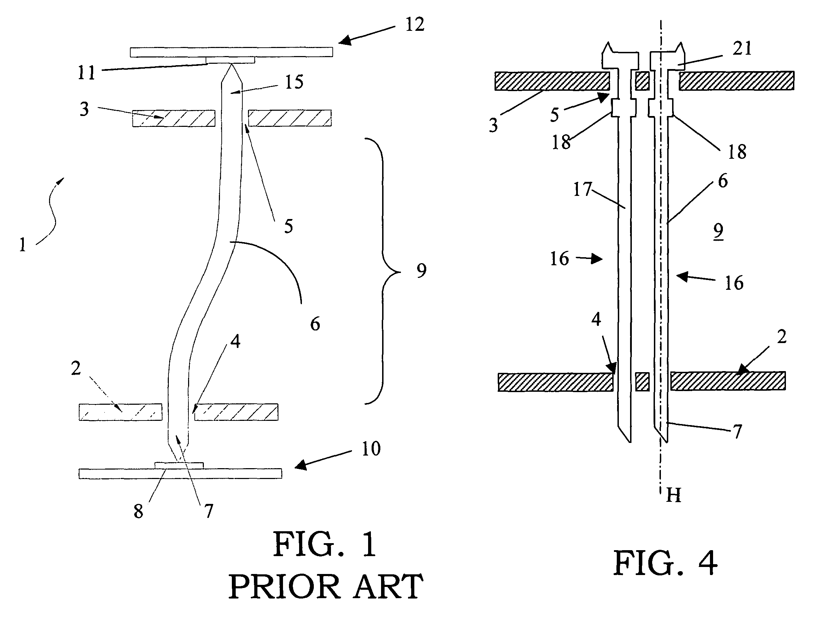

Basically, vertical probe testing heads have an air gap in which a bending of the contact probes takes place, such bending being able to be helped through a suitable configuration of the probes themselves or of their guides, as schematically illustrated in figure 1, where for the sake of simplicity of illustration just one contact probe of the plurality of contact probes normally included in a testing head has been represented.

In particular, figure 1 schematically illustrates a testing head 1 comprising at least an lower guide 2 and a upper guide 3, having respective upper and lower guide holes 4 and 5 respectively, in which at least one contact probe 6 slides.

The contact probe 6 terminates at one end with a contact tip 7 intended to abut against a contact pad 8 of a device to be tested 10, thus making the mechanical and electrical contact between said device to be tested 10 and a testing apparatus (not represented) of which such testing head constitutes a terminal element.

With the term "contact tip", an area or region is indicated of a contact probe intended for contact with the device to be tested or the testing apparatus, said contact area or region not necessarily being pointed.

In some cases, the contact probes are fixedly connected to the head itself at the upper guide: in this case they are testing heads with locked probes.

More frequently, however, testing heads are used that have probes that are not fixedly connected, but held interfaced with a so-called board, possibly by means of a microcontactor, which is called space transformer: in this case they are testing heads with unlocked probes.

In this case, as illustrated in figure 1, the contact probe 6 has a further contact tip 15 towards a pad 11 of a plurality of contact pads of the space transformer 12. The good electrical contact between probes 6 and space transformer 12 is ensured in an analogous way to the contact with the device to be tested 10 through the pressing of the contact tips 15 of the probes 6 on the contact pads 11 of the space transformer 12.

The upper 3 and lower 2 guides are suitably spaced from an air gap 9 that allows the deformation of the contact probes 6. Finally, the guide holes 4 and 5 are sized so as to allow the contact probe 6 to slide inside them.

The shape of the deformation undergone by the probes and the force necessary to produce such deformation depend upon numerous factors, such as the physical characteristics of the alloy that makes up the probes and the value of the misalignment between guide holes in the upper guide and corresponding guide holes in the lower guide.

The correct operation of a testing head is fundamentally linked to two parameters: the vertical displacement, or overtravel, of the contact probes and the horizontal displacement, or scrub, of the contact tips of such contact probes. In particular, it is extremely important to ensure the scrub of the contact tips so to allow scraping the surface of the contact pads, removing the impurities and thus improving the contact made by the testing head.

All of these characteristics should be evaluated and calibrated in the step of making a testing head, the good electrical connection between probes and device to be tested having to always be ensured. In the case of a testing head 1 made with technology known as "shifted plate" technology, the contact probes 6 are made straight, with a constant circular cross section for the entire length and in general pointed at the ends to form the contact tips 7 and 15, as illustrated in figure 1.

One drawback of the testing heads of the aforesaid type lies in the possibility of the contact probes dropping out from the respective guide holes, in particular when the guide holes are still aligned, i.e. before the upper and lower guides are shifted in order to prepare the testing head for a test cycle.

Regarding thus, the patent US 6,150,830 (in particular figure 4 and related description) describes a testing head with unlocked probes comprising an upper plate-shaped support and a lower plate-shaped support equipped with respective guide holes, in which respective contact probes are slidable, every contact probe having a rod-shaped body with predetermined longitudinal axis coated, over a considerably longitudinal portion thereof, with an insulating material and terminating with respective contact tips.

In particular, such coating has a transverse dimension greater than that of the guide holes of the lower plate-shaped support, so to prevent the dropping by gravity of the contact probes through them, in particular if the guide holes of the lower plate-shaped support are aligned with the guide holes of the upper support.

Although the testing head described in the patent US 6,150,830 substantially meets the aforesaid object, it nevertheless involves further drawbacks.

In fact, the use of a coating on a considerable portion of the contact probes involves considerable additional costs, and moreover such coating must be made with significant thicknesses so that it can effectively retain the contact probes in the respective guide holes.

Moreover, the use of significant thicknesses for the insulating coating of the rod-shaped body does not permit reducing the pitch between the contact probes beyond a certain limit, thus making the functionality check by means of the aforesaid testing head difficult if not impossible of electronic devices having particularly reduced sizes.

Finally, it should be noted that in the testing heads of the prior art described above, there is the drawback that the accidental (partial or total) upward exit of the contact probes from the respective guide holes is not prevented.

Such drawback is rather frequent if it is necessary to remove the interface board of the testing device with the testing head (Printed Circuit Board (PCB) or space transformer), for example in case of inspections, of defective and/or non-functioning contact probe substitutions and/or of periodic cleaning operations of the contact tips which, in operating conditions, are in abutment against the contact pads of said board.

It thus frequently occurs that some contact probes can be removed together with the board, thus exiting upward from the respective guide holes, due to the strong adhesions with the respective contact pads of the board which form during the functioning of the testing head.

In addition, as is known, the aforesaid cleaning operations are normally carried out by means of ultrasounds or a compressed air flow, so to remove possible impurities that have adhered to the tips of the contact probes, such impurities being mainly composed of aluminium particles deriving from the scrub of the contact pads, whose presence tends to compromise the good electrical contact with the contact pads of the testing device and thus the correct functionality of the testing head.

Nevertheless, in such a manner, the contact probes are subjected to mechanical stresses, which have the effect of pushing the probes upward, until they partially or totally exit from the respective guide holes, notwithstanding the opposing action due to the peripheral contact of the probes with the respective walls of the shifted guide holes, which would tend to keep the probes in the correct position.

It should moreover be noted that a similar drawback is sometimes encountered even during the transportation of the testing head, since in this case the interface board has not yet been installed and the contact probes inserted between the shifted guides can be subjected to considerable mechanical stresses.

It is therefore evident that even where means are provided for preventing the contact probes dropping from the respective guide holes, as in the testing head of the patent US 6,150,830, there is the need to prevent the inadvertent upward exit of the probes from the respective guide holes, in particular during the abovementioned operations.

The technical problem underlying the present invention is therefore that of devising a testing head for microstructures having characteristics such to prevent the contact probes from inadvertently upwardly exiting from the respective guides, so to meet the aforesaid need.

### Summary of the invention

Such technical problem is resolved by a testing head with non-locked vertical probes for checking the functionality of a electronic device to be tested comprising a lower plate-shaped support equipped with at least one lower guide hole, an upper plate-shaped support equipped with at least one upper guide hole and at least one contact probe housed in a corresponding lower guide hole and a corresponding upper guide hole, every contact probe comprising a rod-shaped central body with predetermined longitudinal axis that is axially slidable in said corresponding lower guide hole and said corresponding upper guide hole, **characterised in that** said at least one contact probe comprises stopping means formed on said rod-shaped body and adapted to abut against at least one of said lower plate-shaped support and upper plate-shaped support following a predetermined upward sliding of said rod-shaped body, so that to prevent the upward exit of said at least one contact probe from said corresponding lower guide hole and said corresponding upper guide hole.

Preferably, in the testing head according to the invention the upper plate-shaped support is turned towards the contact pads of a testing device and the lower plate-shaped support is turned towards the contact pads of said device to be tested. In addition, the upper plate-shaped support and the lower plate-shaped support are shifted with each other in use, so that said rod-shaped body of every contact probe is laterally in contact with a guide wall of a corresponding guide of said upper plate-shaped support and/or a guide wall of a corresponding guide of said lower plate-shaped support.

According to one embodiment of the invention, the stopping means comprise, for each contact probe, at least one tooth formed on said side of the rod-shaped body in contact with said guide wall of the corresponding guide hole of said upper plate-shaped support, said at least one tooth being adapted to abut from below against said upper plate-shaped support following said predetermined upward sliding of the rod-shaped body.

Preferably, said stopping means comprise, for each contact probe, a pair of teeth formed on respective axially opposed sides of said rod-shaped body, alternately in contact with a respective guide wall of the corresponding guide hole of said upper plate-shaped support, said teeth being adapted to alternately abut from below against said upper plate-shaped support following said predetermined upward sliding of said rod-shaped body.

According to one aspect of the present invention, the testing head further comprises means for preventing the drop by gravity of said at least one contact probe through said corresponding lower guide hole and said corresponding upper guide hole.

In accordance with a particularly preferred embodiment, such means for preventing the drop by gravity comprise, for each contact probe, an end portion projecting from said rod-shaped body and terminating with a contact tip for the mechanical and electrical contact with a corresponding contact pad of a testing device, said end portion being situated above said upper plate-shaped support and having dimensions greater than that of said upper guide hole.

Preferably, said contact tip is arranged on said end portion in an eccentric manner with respect to the longitudinal axis of the rod-shaped body.

According to another embodiment of the invention, said means for preventing the drop by gravity comprise, for each contact probe, at least one second tooth formed on said side of the rod-shaped body in contact with said guide wall of the corresponding lower guide hole, said at least one tooth being adapted to abut from above against said lower plate-shaped support following a predetermined downward sliding of said rod-shaped body.

Preferably, said means for preventing the drop by gravity comprise, for each contact probe, a pair of second teeth formed on respective axially opposed sides of said rod-shaped body, alternately in contact with a respective guide wall of the corresponding lower guide wall, said teeth being adapted to alternately abut from above against said lower plate-shaped support following said predetermined downward sliding of said rod-shaped body.

The invention also regards a contact probe for a testing head with vertical probes of the aforesaid type, the probe having the abovementioned structural characteristics.

The characteristics and advantages of the testing head and contact probes according to the invention will be clear from the following description of several preferred embodiments, given as indicative and non-limiting with reference to the attached drawings.

### Brief description of the drawings

In such drawings:
Figure 1 schematically shows a testing head made according to the prior art;
Figure 2 schematically shows a testing head according to the invention in an operative position;
Figure 3 schematically shows the stopping of the upward sliding of contact probes according to the invention in the testing head of figure 2;
Figure 4 schematically shows an assembly step of contact probes according to the invention in the testing head of figure 2.

### Detailed description

Figure 1 shows a testing head made according to the prior art and already described previously.

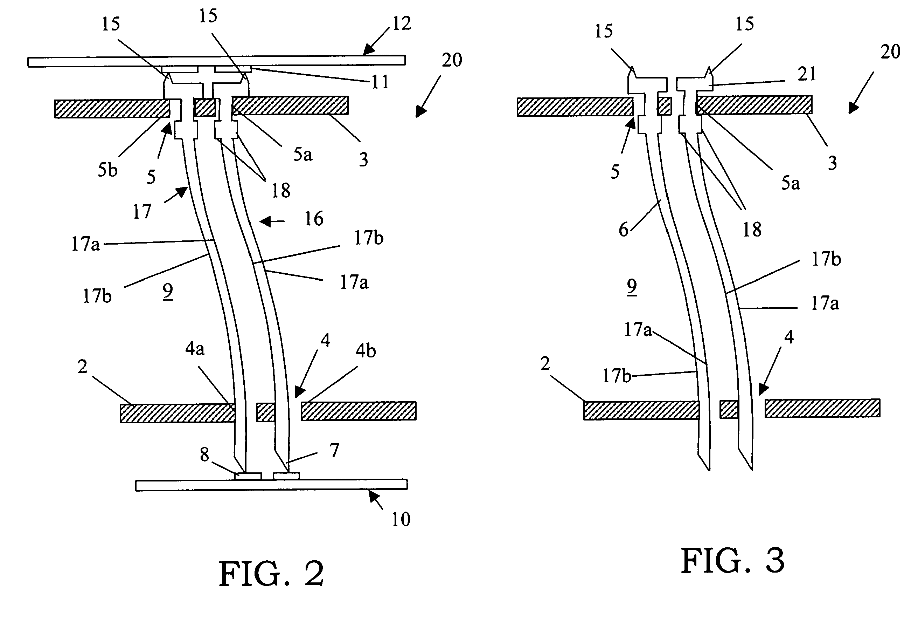

With reference to figures 2-4, a testing head made according to the invention is indicated with 20.

Elements of the testing head 20 that are structurally and functionally equivalent to corresponding elements of the testing head 1 described above shall be attributed the same reference numerals.

The testing head 20 comprises an upper guide 2 and a lower guide 3 spaced from each other by an appropriate air gap 9, the lower zone 2 and the upper zone 3 having respective lower guide holes 4 and upper guide holes 5 within which respective contact probes 16 are housed. For the sake of simplicity, in figures 2-4 only two contact probes 16 are illustrated, housed in the respective lower guide holes 4 of the lower guide 2 and in the upper guide holes 5 of the upper guide 3.

Each contact probe 16 comprises a rod-shaped body 17 with predetermined longitudinal axis H and axially slidable in the respective lower guide hole 4 and in the respective upper guide hole 5, the rod-shaped body 17 terminating at the upper end with a first contact tip 15 and the lower end with a second contact tip 7.

In the present embodiment, the rod-shaped body 7 has a polygonal cross section, preferably rectangular or square.

In the operative condition of the testing head 20, illustrated in figure 2, the second contact tip 7 of every contact probe 16 is in pressing contact against a corresponding contact pad 8 of device 10 to be tested, thus ensuring the electrical and mechanical contact with such pad 8 while the first contact tip 15 is in pressing contact against a corresponding contact pad 11 of an interface board of a testing device, for example a space transformer 12, thus ensuring the electrical and mechanical contact with such contact pad 11.

Moreover, the upper guide 3 and lower guide 2 are shifted from each other so to permit a preferential bending of the contact probes 16 in the same direction and their locking in position by means of lateral contact of the rod-shaped body 17, with one side 17a against an upper guide wall 5a of a respective upper guide hole 5 and with a corresponding side 17b against a guide wall 4a of a respective lower guide hole 4.

Such locking does not nevertheless prevent the sliding of the rod-shaped body 17 of the contact probes 16 while they are maintained in laterally scraping contact with the guide wall 5a of a respective guide hole 5 and with a guide wall 4a of a respective lower hole 4, such sliding in particular occurring during a vertical overtravel movement in order to bring the second contact tip 7 in pressing abutment against a contact pad 8 and the first contact tip 15 in pressing abutment against a corresponding contact pad 11 of the space transformer 12.

In accordance with the present invention, the rod-shaped body 17 of the contact probes 16 comprises stopping means for preventing the upward exit of the contact probes 16 from the respective upper guide hole 5 and from the respective lower guide hole 4.

In the present embodiment, such stopping means comprise a pair of teeth 18 formed integrally with the rod-shaped body 17, each on a respective side 17a or 17b respectively in contact with the upper guide hole 5 and the lower guide hole 4.

More in particular, in the present embodiment, the teeth 18 are arranged at a predetermined height of the rod-shaped body 17 of a respective contact probe 16, so that in the operative measuring condition of the testing head 20, illustrated in figure 2, they are situated in the air gap 9 near the upper guide 3, without the possibility of interference therewith.

In the case of accidental upward sliding of a contact probe 16 (or a plurality thereof), for example with the removal of the space transformer 12 or cleaning operations of the second contact tips 15, one of the teeth 18, and precisely the tooth 18 which is arranged on the side in contact with a respective wall of the upper guide hole 5, abuts from below against the upper guide 3, thus preventing the exit of the contact probes 16 from the respective lower 4 and upper 5 guide holes.

Such situation is schematically illustrated in figure 3 for two contact probes 16 with regard to their tooth 18 arranged on the side 17a of the rod-shaped body 17 in contact with a wall 5a of a respective upper guide hole 5. In case of accidental upward sliding of the contact probes 16, such tooth abuts from below against the upper guide 3 at the wall 5a of a respective upper guide hole 5, thus preventing the exit of the contact probes 16 from the respective lower 4 and upper 5 guide holes.

Of course, if the contact probes 16 are deformed (bent) in the direction opposite that shown in figure 3, so that the rod-shaped body 17 is in contact with the opposite side 17b against a wall 5b (opposite the aforesaid wall 5a) of a respective upper guide hole 5, it will instead be the tooth 18 situated on said side 17b in contact with the wall 5b of the upper guide hole 5 to abut from below against the upper guide 3 at said wall 5b, thus preventing the exit of the contact probes 16 from the respective lower 4 and upper 5 guide holes.

In accordance with a preferred aspect of the invention, the testing head 20 further comprises means for preventing the drop by gravity of the contact probes 16 through the respective lower guide holes 4 and upper guide holes 5.

For such purpose, in the present embodiment, each contact probe 16 comprises an upper end portion 21 projecting from the rod-shaped body 17 and terminating with the second contact tip 15 for the electrical and mechanical contact with a respective contact pad 11 of a testing device 12.

Such end portion, substantially an arm 21, is situated in the testing head 20 atop the upper guide 3 and has greater size than the upper guide holes 5 of the upper guide 3, thus preventing both the drop by gravity of the contact probes 16 through the respective upper guide holes 5 and lower guide holes 4 and their accidental downward exit from the respective upper 5 and lower 4 guide holes, for example during cleaning operations of the first contact tips 7 (i.e. the contact tips with the pads 8 of the device to be tested 10).

To this end, it should in fact be noted that such cleaning operations are carried out at the end of one or more test cycles by means of a wafer provided with a layer of a suitable abrasive cleaning material, which is brought into pressing contact against the contact tips to be cleaned, thus permitting the removal of said impurities from the tips and their subsequent elimination once the wafer is brought away from the contact tips.

Nevertheless, it frequently occurs that during the cleaning operations, the contact tips tend to strongly adhere to the cleaning layer of the wafer, to the point that when the wafer is removed, they tend to fixedly go with it, exiting from the respective guide holes of the testing head.

However, due to the present invention, such exit is prevented by the end portion 21 of the contact probes, as in case of a predetermined accidental downward sliding of the contact probes 16, such portion abuts from above on the upper guide 3, thus preventing the exit of the probes 16 from the respective lower guide holes 4 and upper guide holes 5.

It should be noted that the second contact tips are arranged on the end portion 21 in a preferably eccentric manner with reference to the longitudinal axis H of the rod-shaped body. This permits configuring the contact probes 16 with the respective end portions 21 oriented in a suitable manner so to obtain an adequate widening of the pitch between the contact pads 11 of the testing device 12 which are associated with consecutive contact probes 16 with respect to the pitch between the corresponding contact pads 8 of the device 10 to be tested which are associated with said consecutive contact probes 16.

According to an alternate embodiment of the invention, the means for preventing the drop by gravity of the contact probes 16 through the respective lower guide holes 4 and the respective upper guide holes 5 comprise, for each contact probe 16, at least one second tooth (not shown) formed on the side 17a or 17b of the rod-shaped body 17 in contact with the guide wall 4a or 4b of the corresponding lower guide hole 4, said at least one second tooth 18 being adapted to abut from above against the lower plate-shaped support 2 following a predetermined downward sliding of said rod-shaped body 17.

Preferably, said means comprise, for each contact probe 16, a pair of second teeth (not shown) formed on respective axially opposed sides 17a and 17b of said rod-shaped body 17, alternately in contact with a respective guide wall 4a, 4b of the corresponding lower guide hole. Such teeth are situated on the rod-shaped body 17 at a predetermined height such that, in the operative condition of the testing head 20 illustrated in figure 2, they are near the lower guides 2 without the possibility of interfering therewith and in a manner such that they alternately abut from above against said lower plate-shaped support 2 following said predetermined downward sliding of said rod-shaped body 17.

Regarding the assembling of the contact probes 16 in the testing heads 20, it should be said that the first operation comprises the insertion of the straight-manufactured contact probes 16 in the respective upper guide holes 5 and lower guide holes 4 maintained aligned with each other by means of a corresponding alignment of the upper guide 3 with the lower guide 2.

To such end, it should be noted that the upper guide holes 5 are appropriately shaped so to allow the passage of the rod-shaped body 17 of the contact probes 16 with the respective first contact tips 8 and respective stopping means (teeth 18) but not the respective end portions 21 terminating with the second contact tips 15.

The result of such operation is schematically illustrated in figure 4 for two contact probes 16, where it is also noted that the upper end portion 21 abutting from above against the upper guide 3 advantageously prevents the drop by gravity of the contact probes 16 through the respective upper 5 and lower 4 guide holes.

Then, the lower guide 2 and the upper guide 3 are shifted from each other by a pre-established amount, so to lock the contact probes in position.

Finally, a vertical overtravel movement operated on the contact probes 16 allows placing the first contact tips 7 in pressing contact with the contact pads 8 of the device to be tested 10 and the second contact tips 15 with the contact pads 11 of the space transformer 12, thus bringing the testing head 20 into the operative measuring condition as represented in figure 2.

The main advantage of the testing head according to the invention lies in the highly effective and simple manner in which the accidental upward exit of the contact probes from the respective guide holes is prevented.

In addition, the use of stopping means only on sides of the rod-shaped body of the probes (in particular on two opposite sides) intended to come into contact with the respective walls of the guide holes permits considerably reducing the pitch between the contact probes, thus making it possible to employ the testing head according to the invention also for the functionality checking of electronic devices having particularly reduced sizes.

It should be noted that in the testing head of the invention the contact probes can be slightly upwardly divergent due to the fact that the pitch between the contact pads of the testing device is normally greater than the pitch between the corresponding contact pads of the device to be tested. In such a manner, greater free space is created in the upper part of the testing head between adjacent contact probes, thus making the stopping means device (teeth 18) near the upper guide of the testing head particularly convenient and advantageous in addition to considerably reducing the risk of interference between the stopping means of adjacent probes.

Another advantage of the present invention lies in the fact that the contact probes are made in a simple manner, with reduced costs, since they can be made integrally with the respective stopping means, in a single piece directly from a mould by means of conventional photolithograph technologies, for example by means of MEMS technologies (Micro Electro-Mechanical System). In addition, such stopping means affect a very reduced section of the rod-shaped body and can be made with sizes (in particular thicknesses) that are particularly reduced.

Of course, numerous modifications and variants can be made to the testing head and contact probe according to the invention, all moreover comprised in the protective scope of the attached claims.

## Claims

1. Testing head (20) with unlocked vertical probes for checking the functionality of an electronic device (10) to be tested comprising a lower plate-shaped support (2) provided with at least one lower guide hole (4), an upper plate-shaped support (3) provided with at least one upper guide hole (5), and at least one contact probe (16) housed in a corresponding lower guide hole (4) and a corresponding upper guide hole (5), each contact probe (16) comprising a rod-shaped central body (17) with predetermined longitudinal axis (H) that is axially slidable in said corresponding lower guide hole (4) and said corresponding upper guide hole (5), **characterised in that** said at least one contact probe (16) comprises stopping means formed on said rod-shaped body (17) and adapted to abut against at least one of said lower plate-shaped support (2) and upper plate-shaped support (3) following a predetermined upward sliding of said rod-shaped body (17), so that to prevent the upward exit of said at least one contact probe (16) from said corresponding lower guide hole (4) and said corresponding upper guide hole (5).

2. Testing head (20) according to claim 1, **characterised in that** said upper plate-shaped support (3) and said lower plate-shaped support (2) are shifted from each other such that the rod-shaped body (17) of said at least one contact probe (16) is laterally in contact with a guide wall (5a; 5b) of said corresponding upper guide hole (5) and/or a guide wall (4a; 4b) of said corresponding lower guide hole (4).

3. Testing head (20) according to claim 2, **characterised in that** said stopping means comprise, for each contact probe (16) at least one tooth (18) formed on said side (17a; 17b) of the rod-shaped body (17) in contact with said guide wall (5a; 5b) of the corresponding upper guide hole (5), said at least one tooth (18) being adapted to abut from below against said upper plate-shaped support (3) following said predetermined upward sliding of said rod-shaped body (17).

4. Testing head (20) according to claim 3, **characterised in that** said stopping means comprise, for each contact probe (16), a pair of teeth (18) formed on respective axially opposed sides (17a, 17b) of said rod-shaped body (17), alternately in contact with a respective guide wall (5a, 5b) of the corresponding upper guide hole (5), said teeth (18) being adapted to alternately abut from below against said upper plate-shaped support (3) following said predetermined upward sliding of said rod-shaped body (17).

5. Testing head (20) according to claim 1, **characterised in that** it further comprises means for preventing the drop by gravity of said at least one contact probe (16) through said corresponding lower guide hole (4) and said corresponding upper guide hole (5).

6. Testing head (20) according to claim 5, **characterised in that** said means for preventing the drop by gravity comprise, for each contact probe (16), at least one second tooth formed on said side (17a; 17b) of the rod-shaped body (17) in contact with said guide wall (4a; 4b) of the corresponding lower guide hole (4), said at least one second tooth being adapted to abut from above against said lower plate-shaped support (2) following a predetermined downward sliding of said rod-shaped body (17).

7. Testing head (20) according to claim 6, **characterised in that** said means for preventing the drop by gravity comprise, for each contact probe (16), a pair of second teeth formed on respective axially opposed sides (17a, 17b) of said rod-shaped body (17), alternately in contact with a respective guide wall (4a; 4b) of the corresponding lower guide hole (4), said second teeth being adapted to alternately abut from above against said lower plate-shaped support (2) following said predetermined downward sliding of said rod-shaped body (17).

8. Testing head (20) according to claim 5, **characterised in that** said means for preventing the drop by gravity comprise, for each contact probe (16), an end portion (21) projecting from said rod-shaped body (17) and terminating with a contact tip (15) for the mechanical and electrical contact with a corresponding contact pad (11) of a testing device (12), said end portion (21) being situated atop said upper plate-shaped support (3) and having dimensions greater than those of said upper guide hole (5).

9. Testing head according to claim 8, **characterised in that** said contact tip (15) is arranged on said end portion (21) in an eccentric manner with respect to the longitudinal axis (H) of said rod-shaped body (17).

10. Contact probe (16) for a testing head (20) with vertical probes according to any one of the preceding claims, comprising a central rod-shaped body (17) with predetermined longitudinal axis (H) that is axially slidable in a corresponding lower guide hole (4) of said lower plate-shaped support (2) and in a corresponding upper guide hole (5) of said upper plate-shaped support (3), **characterised in that** it comprises stopping means formed on said rod-shaped body (17) adapted to abut against at least one of said lower plate-shaped support (2) and upper plate-shaped support (3) following a predetermined upward sliding of said rod-shaped body (17), in order to prevent the upward exit of said contact probe (16) from said corresponding lower guide hole (4) and said corresponding upper guide hole (5).

11. Contact probe (16) according to claim 10, **characterised in that** said stopping means comprise at least one tooth (18) formed on one side (17a; 17b) of said rod-shaped body (17) intended to be, in use, in contact with a guide wall (5a, 5b) of the corresponding upper guide hole (5) of said upper plate-shaped support (3).

12. Contact probe according to claim 10, **characterised in that** said stopping means comprise a pair of teeth (18) formed on respective axially opposed sides (17a, 17b) of said rod-shaped body (17) and intended to be alternately in contact with a respective guide wall (5a, 5b) of the corresponding upper guide hole (5) of said upper plate-shaped support (3).

13. Contact probe (16) according to claim 10, further comprising means for preventing the drop by gravity through said corresponding lower guide hole (4) and said corresponding upper guide hole (5).

14. Contact probe (16) according to claim 13, **characterised in that** said means for preventing the drop by gravity comprise an end portion (21) projecting from said rod-shaped body (17) and terminating with a contact tip (15) for the mechanical and electrical contact with a corresponding contact pad (11) of a testing device (12), said end portion (21) being situated atop said upper plate-shaped support (3) and having dimensions greater than those of said upper guide hole (5).

15. Contact probe (16) according to claim 14, **characterised in that** said contact tip (15) is arranged on said end portion (21) in an eccentric manner with respect to the longitudinal axis (H) of said rod-shaped body (17).
